**Europäisches Patentamt**

**European Patent Office**

**Office européen des brevets**

(19)

(11) Veröffentlichungsnummer: **0 077 520**

**A2**

## (12) EUROPÄISCHE PATENTANMELDUNG

(21) Anmeldenummer: **82109439.8**

(22) Anmeldetag: **13.10.82**

(51) Int. Cl.³: **H 01 L 29/60**
**G 11 C 11/34**

(30) Priorität: **19.10.81 DE 3141390**

(43) Veröffentlichungstag der Anmeldung:
**27.04.83 Patentblatt 83/17**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(84) Benannte Vertragsstaaten:
**DE**

(71) Anmelder: **ITT INDUSTRIES INC.**
**320 Park Avenue**
**New York, NY 10022(US)**

(84) Benannte Vertragsstaaten:
**FR GB IT NL**

(72) Erfinder: **Adam, Fritz Günter Dipl.-Phys. Dr. rer. nat.**
**Furtwänglerstrasse 10**
**D-7800 Freiburg i.Br.(DE)**

(74) Vertreter: **Stutzer, Gerhard, Dr.**
**Deutsche ITT Industries GmbH Patent- und**
**Lizenzabteilung Hans-Bunte-Strasse 19 Postfach 840**
**D-7800 Freiburg(DE)**

(54) **Floating-Gate-Speicherzelle, bei der das Schreiben und Löschen durch Injektion heisser Ladungsträger erfolgt.**

(57) In der Floating-Gate-Speicherzelle, welche aus einer Source-Drain-Reihenschaltung eines Speichertransistors (Ts) mit einem Auswahltransistor (Ta) besteht, die als Isolierschichtfeldeffekttransistoren ausgebildet sind, weist der Speichertransistor (Ts) eine Floating-Gate-Elektrode (Fg) auf. Das Kanalgebiet (Cs) des Speichertransistors (Ts) geht unmittelbar in das Kanalgebiet (Ca) des Auswahltransistors (Ta) über. Die beiden Kanalgebiete stellen zusammen eine Verbindung zwischen einer Leseleitungszone (Y) und einer Programmierleitungszone (X) her und werden mit ihrer seitlichen Begrenzung als Teil eines Gateoxidbereichs (Co) definiert, der auf der Auswahltransistorseite die Leseleitungszone (Y) um ein kleines Stück (Cy) überlappt, auf der Speichertransistorseite aber die Programmierleitungszone (X) uberkreuzt (Cx) und noch um einen kleinen Fortsatz (Cf) überragt und der von einem Gebiet dicken Feldoxids (4) umgeben ist. Vom Kanalgebiet (Cs) aus gesehen ist jenseits der Programmierleitungszone (X) eine Programmierzone (Pz) mit erhöhter Substratdotierung so ins Substrat eingebracht, daß sie entweder

a) die Programmierleitungszone (X) nicht überlappt, aber sich dieser mit ihrem Rand im mittleren Bereich der Grenzlinie zwischen Cx und Cf bis auf einen sehr kleinen Abstand (a) nähert, oder daß sie

b) die Programmierleitungszone (X) auf einem Teil von deren Breite überlappt und mit ihrer Randlinie den Rand der Programmierleitungszone (Pz) etwa auf dem Schnittpunkt (M) der Grenzlinie zwischen (Cx) und (Cf) unter einem Winkel (W) größer als 30° schneidet.

Das Floating-Gate (Fg) überlappt das gesammte Gateoxidgebiet (Co) mit Ausnahme des zum Auswahltransistors (Ta) gehörenden Kanalgebiets (Ca) sowie die angrenzenden Bereiche des Feldoxids (4). An das oberflächlich oxidierte Floating-Gate (Fg) ist kapazitiv ein Steuergate (G) angekop-

./...

pelt, welches das Kanalgebiet (Ca) des Auswahltransistors (Ta) überdeckt und neben der Leseleitungszone (Y) und der Programmierleitungszone (X) als dritte Elektrode dient.

FIG.1

FIG.2

0077520

F. G. Adam 50

Fl 1105 EP
Go/Be
12.10.1982

Floating-Gate-Speicherzelle, bei der das Schreiben und
Löschen durch Injektion heißer Ladungsträger erfolgt

Die Erfindung beschäftigt sich mit der Ausbildung einer
Floating-Gate-Speicherzelle, d. h. einer Speicherzelle
mit einer potentialmäßig schwebenden Gateelektrode, welche
mittels Injektion heißer Ladungsträger durch eine dünne
Oxidschicht zwischen Substratkristall und Elektrode
auf- oder entladen wird, wobei der Schwellwert eines als
Isolierschicht-Feldeffekttransistor ausgebildeten Speichertransistors verschoben wird. Dabei erfolgt z. B. das Schreiben mittels Injektion heißer Elektronen und das Löschen durch
Injektion heißer Löcher.

Speicherzellen dieser Art sind aus den folgenden Aufsätzen
bekannt:

a) W.M.Gosney, "IEEE Trans. on Electron Devices",
Mai 1977, Seite 594 - 599, "DIFMOS-A Floating-Gate
Electrically Erasable Nonvolatile Semiconductor
Memory Technology"

b) T.Ito et al, "IEEE Trans. on Electron Devices",
Juni 1979, Seite 906 - 913, "Low Voltage Alterable
EAROM Cells with Nitride-Barrier Avalanche-Injektion
MIS (NAMIS)"

Die "DIFMOS-Speicherzelle weist einerseits folgende Nachteile auf:

- Zur Herstellung wird die AL-Gate-P-Kanal-Technologie
angewendet, so daß für eine Zelle eine relativ große
Fläche (25 800 $\mu m^2$) benötigt werden.
- Sie benötigt getrennte Diodenstrukturen mit spezieller
Dotierung, nämlich eine $P^{++}/N^+$-Struktur für die
Elektroneninjektion und eine $N^{++}/P^+$-Struktur für
die Löcherinjektionen.

F. G. Adam 50                              F1 1105 EP

- Sie ist nicht kompatibel mit der modernen N-Kanal-
  Si-Gate-Technologie.

Andererseits sind bei der "NAMIS"-Speicherzelle folgende Nachteile zu verzeichnen:

- Die Injektion findet innerhalb des Kanalgebiets des Speichertransistors statt, so daß sich in relativ kurzer Zeit die Kennlinie des Speichertransistors durch im Gateisolator getrappte Ladungen verändert.

- Zwischen der Floating-Gateelektrode und dem Kanalbereich wird ein extrem dünnes thermisches Nitrid (9,5 nm) verwendet, zu dessen Herstellung ein thermischer Nitridierungsprozess erforderlich ist, der hohe Temperaturen zwischen 1200 und 1300$^{\circ}$C benötigt, die mit modernen Standard- Technologien nicht kompatibel sind.

Die Erfindung betrifft somit eine Floating-Gate-Speicherzelle gemäß dem Oberbegriff des Anspruchs 1.

Aufgabe der Erfindung ist die Angabe einer platzsparenden Floating-Gate-Speicherzelle dieser Art, wobei die Injektion von Ladungsträgern außerhalb des Transistorkanalgebiets stattfindet, und zwar für Elektronen und Löcher an sehr eng benachbarten Stellen auf der einen bzw. der anderen Seite eines PN-Übergangs.

Diese Aufgabe wird durch die im kennzeichnenden Teil des Anspruchs 1 angegebene Ausbildung gelöst.

Der erwähnte PN-Übergang wird gebildet an der Grenze zwischen der $n^+$-dotierten Programmierleitungszone X und der $p^+$dotierten Programmierzone Pz.

Die Funktionsweise der Speicherzelle nach der Erfindung beruht darauf, daß bei Anlegen eines positiven Programmierimpulses an die Gateelektrode bei gleichzeitigem Anliegen der Programmierspannung am PN-Übergang die maximale Feldstärke

F. G. Adam 50 Fl 1105 EP

auf der $P^+$-Seite des Übergangs unter dem Dünnoxid innerhalb des Fortsatzes des Gateoxidgebietes auftritt und die Injektion heißer Elektronen bewirkt, während bei Anlegen eines negativen Impulses die maximale Feldstärke auf der $N^+$-Seite des Übergangs unter dem Dünnoxid auftritt und zur Injektion heißer Löcher führt.

Eine Erniedrigung der Programmierspannung kann in Weiterbildung des Erfindungsgedankens dadurch erzielt werden, daß das Gateoxid im Bereich des Fortsatzes ein Dünnschichtfenster mit einem besonders dünnen Oxid aufweist.

Als Material für das Floating-Gate wird vorzugsweise dotiertes polykristallines Silicium verwendet, da dieses Material relativ leicht thermisch oxidiert werden kann, so daß das Floating-Gate von dem Steuergate leicht elektrisch getrennt werden kann. Das Steuergate kann ebenfalls aus dotiertem polykristallinem Silicium oder auch aus einem Metall, vorzugsweise Aluminium, bestehen.

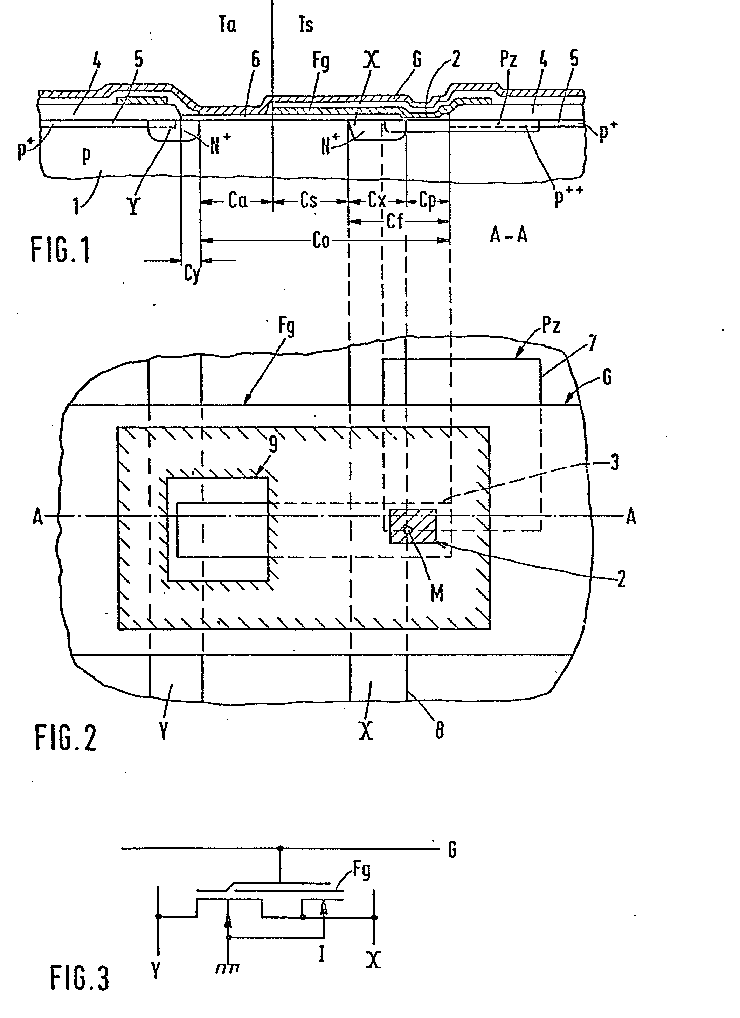

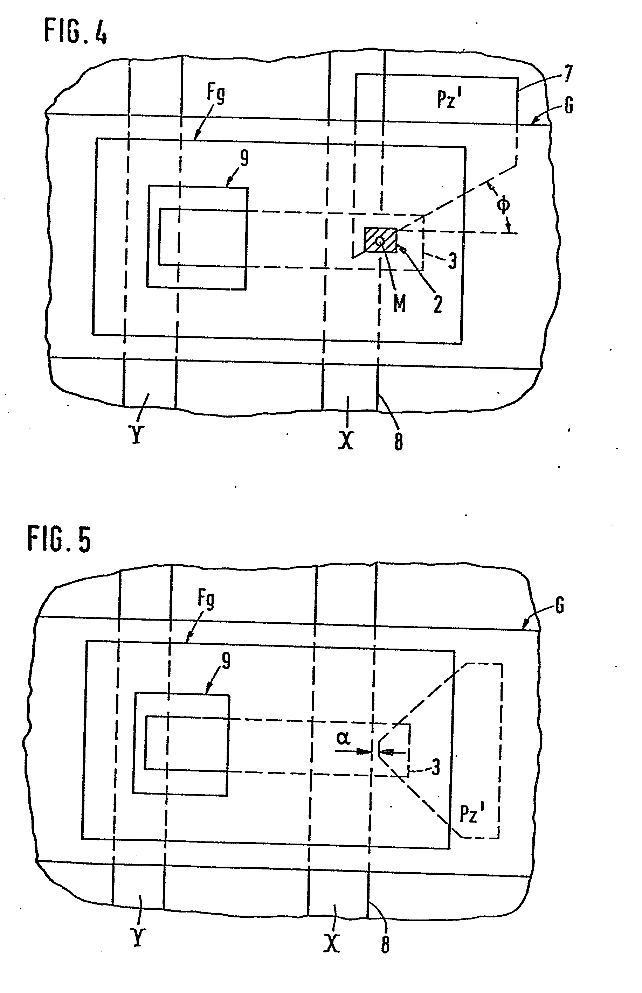

An einem bevorzugten Ausführungsbeispiel einer Floating-Gate-Speicherzelle nach der Erfindung werden im folgenden die Merkmale und Vorteile anhand der Zeichnung erläutert,

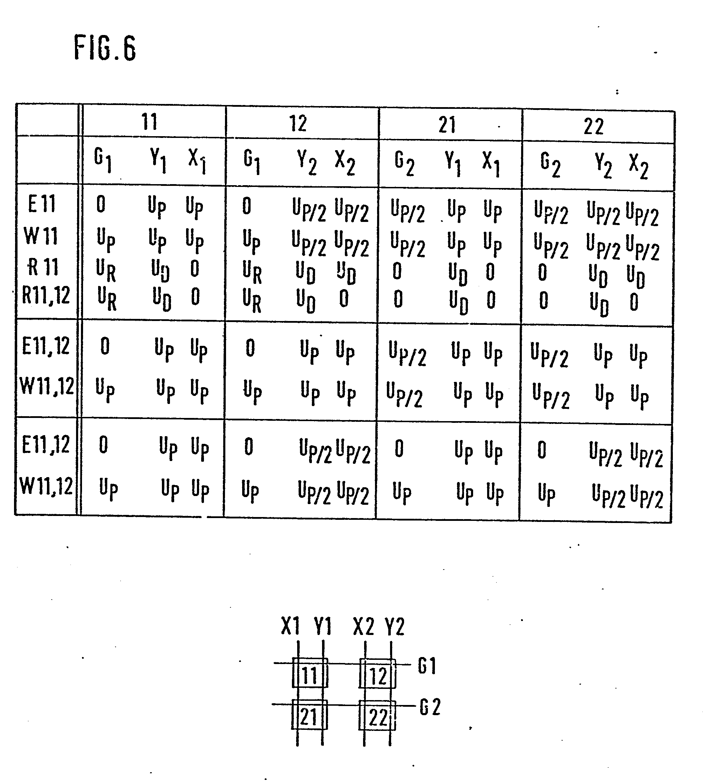

deren Fig. 1 in üblicher Schnittdarstellung als Ausschnitt einer integrierten Festkörperschaltung eine Floating-Gate-Speicherzelle nach der Erfindung zeigt, deren Aufsicht in der Fig. 2 dargestellt ist,

deren Fig. 3 das Schaltbildsymbol der Floating-Gate-Speicherzelle nach der Erfindung bedeutet, wie es sich aus der Fig. 1 und 2 ergibt,

deren Fig. 4 und 5 Weiterbildungen der Floating-Gate-Speicherzelle nach der Erfindung betreffen und

deren Fig. 6 beispielhaft für eine schematisch unter

F. G. Adam 50                                    Fl 1105 EP

der Tabelle dargestellte 2x2-Matrix verschiedene Programmiermöglichkeiten aufzeigt.

Im Hinblick auf die Kompatibilität mit den gegenwärtig
bevorzugten N-Kanal-Technologien wird die Floating-Gate-
Speicherzelle nach der Erfindung vorzugsweise an der Oberfläche eines p-leitenden Substrats 1 oder einer p-leitenden
Substratzone hergestellt. Die Realisierung mit umgekehrten
Polaritäten soll aber nicht ausgeschlossen sein.

Mittels zweier maskierter Implantationsprozesse werden
die Dotierungen der Programmierzone Pz einerseits und
der Leitungszonen X und Y andererseits in die Halbleiteroberfläche eingebracht. Wie bei den heutigen N-Kanal-Technologien für die aktiven Bereiche üblich, werden sodann die
Gateoxidflächen Co mit Nitrid maskiert. Durch thermische
Oxidation wird anschließend das Feldoxid 4 außerhalb des
Randes 3 der mit Nitrid abgedeckten Fläche Co erzeugt. Nach
der Entfernung der Nitridmaskierung erfolgt die thermische
Erzeugung des Gateoxids 6.

Zur Erleichterung des Tunnelns der heißen Ladungsträger
erhält das Gateoxidgebiet Co ein Dünnschichtfenster 2
in einer Dicke zwischen 30 nm und 80 nm.

Bei den Ausführungsbeispielen gemäß den Fig. 2 und 4 ist
etwa auf dem Schnittpunkt der Grenzlinien der Programmierleitungszone X und der Programmierzone Pz ein kleines
Gebiet des Gateoxidgebiets Co als Dünnschichtfenster 2
mit einer solchen dünnen Oxidschicht ausgebildet, um die
Ladungsträgerinjektionen bei besonders kleiner Programmierspannung zu ermöglichen.

Bei den erwähnten Maskierungsprozessen ist der Rand des
Gateoxids 6 bezüglich der Leitungszonen X und Y so zu
legen, daß das Gateoxid 6 einerseits die Leseleitungs-

**0077520**

zone Y leicht überlappt und andererseits einen über die Programmierleitungszone X hinausreichenden Bereich Cp bildet. Ferner hat der Rand des Gateoxids 6 die Programmierzone zu überlappen, so daß innerhalb der Grenzen des hinausragenden Stückes Cp des Fortsatzes Cf unter dem Gateoxidgebiet Co die in das Substrat oberflächlich eingebrachte Programmierzone Pz erhöhter Substratdotierung zu liegen kommt.

Auf diese Weise wird im Hinblick auf den eingangs genannten Aufsatz von W.M. Gosney verständlich, daß bei negativer Polarität der Gateelektrode G der Bereich am Rand 8 der Programmierleitungszone X als Minoritäteninjektor heißer Löcher und bei positiver Polarität der Gateelektrode G der Bereich der Randes 7 der Programmierzone Pz als Minoritäteninjektor heißer Elektronen wirksam werden kann.

Nach der Herstellung des Gateoxids 6, gegebenenfalls mit einem Dünnschichtfenster 2, wird das Floating-Gate Fg aufgebracht, vorzugsweise aus polykristallinem Silicium, da dieses Material leicht durch thermische Oxidation mit einer isolierenden Oberflächenschicht versehen werden kann, welche zur elektrischen Trennung des Floating-Gates Fg vom Steuergate G erforderlich ist. In Fig. 2 ist der Rand des Floating-Gates durch Schraffur hervorgehoben. Es ist rahmenförmig mit einer Aussparung 9 ausgebildet, die das Kanalgebiet Ca des Auswahltransistors Ta einschließt. Auf diese Weise wird eine optimal große Koppelkapazität zwischen dem das angrenzende Gateoxid 4 überlappenden Floating- Gate Fg und der Gateelektrode G erhalten, welche die erstere vollständig bedeckt.

Schließlich wird das Floating-Gate Fg oberflächlich oxidiert und, wie die Fig. 2 veranschaulicht, das bandförmig ausgebildete Steuergate G aufgebracht, welches das oberflächlich

F. G. Adam 50                                          Fl 1105 EP

oxidierte Floating-Gate Fg und damit auch das Kanalgebiet
Ca des Auswahltransistors Ta überdeckt. Dieses Steuergate G bildet neben den kontaktierten Leitungszonen X
und Y die dritte Elektrode der Speicherzelle nach der
Erfindung. Damit geht das Kanalgebiet Cs des Speichertransistors Ts unmittelbar in das Kanalgebiet Ca des Auswahltransistors Ta über und liegt innerhalb eines gemeinsamen
Gateoxidgebietes Co, welches auf der Auswahltransistorseite die Leseleitungszone Y überlappt.

Die Fig. 3 zeigt symbolhaft die Floating-Gate-Speicherzelle nach der Erfindung mit der Leseleitungszone Y, der
Programmierleitungszone X, dem Injektor I, dem Gate G
und dem Floating-Gate Fg. Aus einer solchen Speicherzelle
lassen sich Speichermatrixen mit m x n Speicherplätzen aufbauen. Mit geeigneten Peripherieschaltungen, die Dekodier-,
Logik- und Potentialauswahlschaltungen enthalten, ist
es möglich, entsprechend der Eingabe von binären Kodesignalen

    a) bitweises Löschen und Schreiben

    b) zeilenweises Löschen und Schreiben oder auch

    c) spaltenweises Löschen oder Schreiben zu erzielen.

Unter der Tabelle der Fig. 6 ist eine 2x2-Matrix angegeben, welche vier Speicherzellen nach der Erfindung enthält, welche die Nummern 11, 12, 21 und 22 erhalten haben.
Die Tabelle der Fig. 6 enthält die an die beiden Gateleitungen G1 und G2, die an die beiden Programmierleitungszonen X1 und X2 sowie die an die beiden Leseleitungszonen Y1 und Y2 anzulegenden Spannungen, um die in der ersten
Tabellenspalte angegebenen Funktionen zu bewirken.

F. G. Adam 50                                    Fl 1105  EP

Dabei bedeuten:

$U_P$ die zum Löschen und Schreiben erforderliche Programmierspannung.

$U_R$ und $U_D$ die zum Lesen erforderliche Gate- bzw. Drainspannung, die gleich groß sein können, aber wesentlich
kleiner als $U_P$ zu wählen sind.


In der Tabelle sind zeilenweise folgende Funktionen aufgeführt ($U_P > 0$):

E11:    Nur Zelle 11 wird gelöscht. Löcher werden
        ins Floating-Gate injiziert. Die Schwellenspannung des N-Kanal-Speichertransistors wird
        verkleinert.

W11:    Nur Zelle 11 wird geschrieben. Elektronen
        werden ins Floating-Gate injiziert. Die Schwellenspannung des N-Kanal-Speichertransistors wird
        vergrößert, unter Umständen so stark, daß sie
        das Vorzeichen wechselt, d. h. negativ wird und
        damit den Speichertransistor zum Depletion-Transistor werden läßt.

R11:    Nur Zelle 11 wird gelesen.

R11,12: Zeile 1 der Speichermatrix mit den Zellen
        11 und 12 wird gleichzeitig (parallel) ausgelesen.

E11,12: Zeile 1 wird gelöscht.

W11,12: Zeile 1 wird geschrieben.

E11,21: Spalte 1 wird gelöscht.

W11,21: Spalte 1 wird geschrieben.


Fig. 4 betrifft das Ausführungsbeispiel einer Speicherzelle nach der Erfindung, bei dem die Randlinie der Programmierzone Pz den Rand der Programmierleitungszone X innerhalb des Programmierfensters unter einem Winkel $\emptyset$ von etwa
$60^O$ schneidet.


Die Fig. 5 betrifft das Ausführungsbeispiel einer Speicherzelle nach der Erfindung, bei dem die Programmierzone
Pz die Programmierleitungszone X nicht überlappt,

0077520

F. G. Adam 50                                    Fl 1105 EP

sondern innerhalb des Programmierfensters mit ihrem Rand
dem Rand der Programmierleitungszone X bis auf einen
Abstand a zwischen Null und 6 µm nahekommt. Durch die
Wahl des Winkels $\phi$ bzw. des Abstandes a hat man die
Möglichkeit, eine maximale Feldstärke bei möglichst kleiner
Programmierspannung für optimale Injektion von Elektronen
und Löchern zu erzielen.

F. G. Adam 50                                   Fl 1105 EP
                                                Go/Be
                                                12.10. 1982

<u>Patentansprüche</u>

1. Floating-Gate-Speicherzelle, bei der das Schreiben und Löschen mittels Injektion heißer Ladungsträger erfolgt, bestehend aus einer Reihenschaltung eines Speichertransistors (Ts) und eines Auswahltransistors (Ta), welche als Isolierschichtfeldeffekttransistoren ausgebildet sind, von denen der Speichertransistor (Ts) eine potentialmäßig schwebende Gateelektrode (Fg) aufweist, <u>dadurch gekennzeichnet,</u>
   - daß das Kanalgebiet (Cs) des Speichertransistors (Ts) unmittelbar in das Kanalgebiet (Ca) des Auswahltransistors (Ta) übergeht und innerhalb eines gemeinsamen Gateoxidgebietes (Co) liegt, welches auf der Auswahltransistorseite die Leseleitungszone (Y) überlappt und auf der Speichertransistorseite einen Fortsatz (Cf) aufweist, der über den gegenüberliegenden Rand (8) der Programmierleitungszone (X) mit einem Bereich (Cp) hinausragt,
   - daß innerhalb der Grenzen des hinausragenden Bereiches (Cp) des Fortsatzes (Cf) das Substrat (1) unter dem Gateoxidgebiet (Co) eine oberflächlich eingebrachte Programmierzone (Pz) erhöhter Substratdotierung aufweist,
   - daß das Floating-Gate (Fg) das gesamte Gateoxidgebiet (Co) mit Ausnahme des zum Auswahltransistor (Ta) gehörenden Kanalgebietes (Ca) sowie die angrenzenden Bereiche des Feldoxids (4) überlappt und

**0077520**

F. G. Adam 50                                    Fl 1105 EP

    – daß zur Isolierung und kapazitiven Ankopplung das oberflächlich oxidierte Floating-Gate (Fg)
      und das Kanalgebiet (Ca) des Auswahltransistors
      (Ta) von einem Steuergate (G) überdeckt sind,
      welches wie die Leseleitungszone (Y) und die
      Programmierleitungszone (X) als dritte Elektrode
      der Speicherzelle herausgeführt ist.

2. Speicherzelle nach Anspruch 1, dadurch gekennzeichnet,
    daß das Floating-Gate (Fg) aus dotiertem polykristallinem Silicium besteht.

3. Speicherzelle nach Anspruch 1 oder 2, dadurch gekennzeichnet, daß das Steuergate (G) aus dotiertem
    polykristallinem Silicium oder aus einem Metall,
    beispielsweise Aluminium, besteht.

4. Speicherzelle nach einem der Ansprüche 1 bis 3,
    dadurch gekennzeichnet, daß das Gateoxid (6) im Bereich
    des Fortsatzes (Cf) ein Dünnschichtfenster (2)
    aufweist, das mit dünnerem als oder höchstens gleich
    dickem Oxid wie das Gateoxid (6) über den Kanalgebieten
    (Ca, Cs) ausgebildet ist und dessen Rand (3) sowohl den
    Rand (7) der Programmierzone (Pz) als auch den Rand (8)
    der Programmierleitungszone (X) schneidet.

5. Speicherzelle nach Anspruch 4, dadurch gekennzeichnet,
    daß die Programmierzone (Pz) die Programmierleitungszone (X) nicht überlappt und von dieser innerhalb des
    Dünnschichtfensters (2) einen Abstand im Bereich
    von 0 bis 6 µm aufweist.

6.  Speicherzelle nach einem der Ansprüche 1 bis 4,
    dadurch gekennzeichnet, daß die Programmierzone
    (Pz) die Programmierleitungszone (X) innerhalb des
    Dünnschichtfensters (2) überlappt.

7.  Speicherzelle nach Anspruch 6, dadurch gekennzeichnet,
    daß der Rand (8) der Programmierleitungszone (X) mit
    der Randlinie (7) der Programmierzone (Pz') innerhalb
    des Dünnschichtfensters (2) einen Winkel ($\phi$) zwischen
    $-60^{\circ}$ und $+60^{\circ}$ zur Normalen auf den Rand (8) der
    Programmierleitungszone (X) bildet.

8.  Speicherzelle nach einem der Ansprüche 1 bis 7, dadurch
    gekennzeichnet, daß das Floating-Gate (Fg) rahmenförmig
    mit einer Ausnehmung (9) ausgebildet ist, welche das
    Kanalgebiet (Ca) des Auswahltransistors (Ta) einschließt.

9.  Speicherzelle nach einem der Ansprüche 1 bis 8, dadurch
    gekennzeichnet, daß das Steuergate (G) das Floating-Gate
    (Fg) vollständig überdeckt.

0077520

FIG.1

FIG.2

FIG.3

FIG. 4

FIG. 5

FIG.6

| | 11 | | | 12 | | | 21 | | | 22 | | |
|---|---|---|---|---|---|---|---|---|---|---|---|---|
| | $G_1$ | $Y_1$ | $X_1$ | $G_1$ | $Y_2$ | $X_2$ | $G_2$ | $Y_1$ | $X_1$ | $G_2$ | $Y_2$ | $X_2$ |
| E 11 | 0 | $U_P$ | $U_P$ | 0 | $U_{P/2}$ | $U_{P/2}$ | $U_{P/2}$ | $U_P$ | $U_P$ | $U_{P/2}$ | $U_{P/2}$ | $U_{P/2}$ |
| W 11 | $U_P$ | $U_P$ | $U_P$ | $U_P$ | $U_{P/2}$ | $U_{P/2}$ | $U_{P/2}$ | $U_P$ | $U_P$ | $U_{P/2}$ | $U_{P/2}$ | $U_{P/2}$ |
| R 11 | $U_R$ | $U_D$ | 0 | $U_R$ | $U_D$ | $U_D$ | 0 | $U_D$ | 0 | 0 | $U_D$ | $U_D$ |
| R11,12 | $U_R$ | $U_D$ | 0 | $U_R$ | $U_D$ | 0 | 0 | $U_D$ | 0 | 0 | $U_D$ | 0 |
| E11,12 | 0 | $U_P$ | $U_P$ | 0 | $U_P$ | $U_P$ | $U_{P/2}$ | $U_P$ | $U_P$ | $U_{P/2}$ | $U_P$ | $U_P$ |
| W11,12 | $U_P$ | $U_P$ | $U_P$ | $U_P$ | $U_P$ | $U_P$ | $U_{P/2}$ | $U_P$ | $U_P$ | $U_{P/2}$ | $U_P$ | $U_P$ |
| E11,12 | 0 | $U_P$ | $U_P$ | 0 | $U_{P/2}$ | $U_{P/2}$ | 0 | $U_P$ | $U_P$ | 0 | $U_{P/2}$ | $U_{P/2}$ |
| W11,12 | $U_P$ | $U_P$ | $U_P$ | $U_P$ | $U_{P/2}$ | $U_{P/2}$ | $U_P$ | $U_P$ | $U_P$ | $U_P$ | $U_{P/2}$ | $U_{P/2}$ |